# EUROPÄISCHE PATENTANMELDUNG

(11) **EP 3 593 879 A1**
(43) Veröffentlichungstag der Anmeldung: **15.01.2020**
(21) Anmeldenummer: 19186268.9
(22) Anmeldetag: 15.07.2019
(51) Int. Cl.: A63H 5/00, A63F 9/18, A63F 9/04, A63H 33/22, H03K 17/955, A63F 9/24, H03K 17/96

(54) **MAGISCHE KUGEL**

(30) Priorität: 13.07.2018 DE 202018104041 U
(71) Anmelder: JAST Gifts (Shenzhen) Company Limited, KengZi Sub-district Office, Ping Shan New District GD 518122 Shenzhen City (CN); Green Straw, LLC, Clearwater, FL 33756 (US)
(72) Erfinder: CHEN, Jen-Lin, Cupertino, CA California 95014 (US)
(74) Vertreter: Schneiders & Behrendt PartmbB Rechtsanwälte - Patentanwälte

(57) **Zusammenfassung**

Die Erfindung betrifft eine Vorrichtung zur Ausgabe eines akustischen und/oder optischen Effekts (einer Entscheidungssequenz) mit einem Grundkörper umfassend ein Basiselement (2) mit einer form- und oder kraftschlüssig anbringbaren Abdeckung (3), mindestens einem optischen und/oder mindestens einem akustischen Reizelement, einer Stromversorgung, einem Schaltkreis mit einem Mikroprozessor, einem Zufallsgenerator und einem Speichermedium, und zumindest einem Schalter, wobei durch den zumindest einen Schalter eine Entscheidungssequenz aktivierbar ist, wobei die Entscheidungssequenz per Zufallsgenerator aus mehreren vorgesehenen Entscheidungssequenzen auswählbar ist und in Form eines optischen und/oder akustischen Reizes (Entscheidungssequenz) durch die Reizelemente ausgebbar ist. Auf diese Weise wird eine "magische Kugel" zur Verfügung gestellt, die dem Benutzer eine Entscheidungshilfe bietet.

## Beschreibung

Die Erfindung betrifft eine Vorrichtung mit einer zufallsgesteuerten Ausgabe von Ton- und/oder Lichteffekten.

Auch wenn viele Menschen versuchen, anstehende Entscheidungen objektiv zu fällen, so gibt es Situationen, in denen man am liebsten eine Münze werfen oder auch den sprichwörtlichen Blick in eine magische Kugel, eine Wahrsagerkugel, werfen möchte, um eine Entscheidungshilfe zu erhalten. Dem gewissen Aberglauben, der einer solchen Hilfesuche zugrunde liegt, werden die meisten bekannten Entscheidungshilfen jedoch nicht gerecht. Der Grund hierfür liegt in der meist deutlich wahrnehmbaren Technizität solcher Vorrichtungen, die den Anwender hinwegführt von der Annahme, hier eine gleichsam übersinnliche Entscheidungshilfe zu bekommen.

Es ist daher Aufgabe der Erfindung eine Vorrichtung zur Verfügung zu stellen, die eine Entscheidungshilfe bietet, indem sie in der Art einer magischen Kugel ein Ergebnis ausgibt, beispielsweise in Form eines bestimmten Ton- und/oder Lichteffekts.

Gelöst wird diese Aufgabe durch eine Erfindung mit den Merkmalen des Anspruchs 1. Vorteilhafte Ausgestaltungen sind jeweils Gegenstand der abhängigen Ansprüche. Es ist darauf hinzuweisen, dass die in den Ansprüchen einzeln aufgeführten Merkmale auch in beliebiger und technologisch sinnvoller Weise miteinander kombiniert werden können und somit weitere Ausgestaltungen der Erfindung aufzeigen.

Die Idee der Erfindung liegt darin, dass eine magische Kugel durch die Ausgabe eines bestimmten Licht- oder Toneffekts oder einer Kombination hieraus eine Entscheidungshilfe bietet. Dabei soll die Ausgabe, inklusive beispielsweise einer vorgeschalteten spannungssteigernden Sequenz, durch den Benutzer ohne direkte Berührung der Kugel auslösbar sein. Hierdurch soll dem Anwender das bekannte Umkreisen einer magischen Kugel mit den Händen ermöglicht und somit die Illusion tatsächlicher Magie gesteigert werden. Die Kugel gibt dann, beispielsweise eine bestimmte Zeit nach dem Auslösen oder nach Beendigung der kreisenden Handbewegungen, eine vorbestimmte Entscheidungshilfe aus.

Die Entscheidungshilfe kann einen Licht- und/oder einen Toneffekt umfassen, wobei unter einem Toneffekt eine Sprachausgabe ebenso zu verstehen ist wie Geräusche, Melodien, einzelne Töne etc. sowie Kombinationen hieraus. Unter einem Lichteffekt ist die Ausgabe eines jeglichen Lichtreizes verschiedenster Farben, Sequenzen, Intensitäten etc. sowie Kombinationen hieraus zu verstehen. Eine Entscheidungshilfe umfasst also die Gesamtheit der für sie jeweils vorgesehenen Licht- und/oder Toneffekte.

Die Entscheidung kann eine einfache Ja-Nein-Entscheidung umfassen, es ist jedoch auch denkbar, dass eine Entscheidung zwischen weiteren Möglichkeiten treffbar ist. Je nach Anzahl unterschiedlicher Entscheidungsmöglichkeiten ist eine entsprechende Anzahl unterschiedlicher Entscheidungshilfen vorgesehen.

Die Entscheidungshilfen - bezogen auf eine einfache Ja-Nein-Entscheidung - sind vielfältig und umfassen beispielsweise Licht an für "ja" und Licht aus für "nein", einmal Blinken für "ja" und zweimal Blinken für "nein", grün für "ja" und rot für "nein", Sprachausgabe "ja" für "ja" und Sprachausgabe "nein" für "nein" etc. Es sind verschiedenste Kombinationen möglich, der Kreativität sind hier keine Grenzen gesetzt. Der Fachmann wählt eine entsprechende Ausgabe aus.

Sollten noch weitere Entscheidungshilfen vorgesehen sein, um beispielsweise auch eine Entscheidung zwischen drei oder mehr Möglichkeiten realisieren zu können, so können die Entscheidungshilfen entsprechend um weitere Blinkeffekte, Sprach- oder Toneffekte, Geräusche oder auch Farbsignale erweitert werden, um nur einige Möglichkeiten zu nennen. Der Fachmann wählt eine entsprechende Ausgabe aus.

Eine erfindungsgemäße Vorrichtung umfasst vorzugsweise ein Basiselement und eine Abdeckung, die form- und/oder kraftschlüssig mit dem Basiselement verbindbar ist.

Das Basiselement ist vorzugsweise tellerförmig ausgebildet und gleichzeitig als Sockel und Standfuß für die Abdeckung vorgesehen.

Die Abdeckung ist vorzugsweise kugelförmig und an der Unterseite kraft-und/oder formschlüssig mit dem Basiselement verbindbar, um bei dem Betrachter den Eindruck einer magischen Kristallkugel auf einem Sockel zu erwecken.

Die für den Betrieb der erfindungsgemäßen Vorrichtung notwendige Elektrik und Elektronik ist vorzugsweise auf dem Basiselement angeordnet und mit diesem verbindbar und wird durch die Abdeckung derart gegenüber dem Betrachter abgeschirmt, dass sie diesem gegenüber verborgen bleibt.

Die Elektrik und Elektronik einer erfindungsgemäßen Vorrichtung umfassen mindestens ein optisches und/oder mindestens ein akustisches Reizelement, eine Stromversorgung, einen Schaltkreis mit einem Mikroprozessor, einem Zufallsgenerator und einem Speichermedium sowie zumindest einen Schalter.

Das optische Reizelement umfasst vorzugsweise zumindest eine LED. Die Anzahl und auch die Farbwiedergabe der LEDs wählt der Fachmann nach den speziellen Anforderungen aus, beispielsweise nach der Anzahl der zu verwirklichenden Entscheidungshilfen. Entsprechende Dateien mit bestimmten Lichteffekten sind auf dem Speichermedium hinterlegbar.

Das akustische Reizelement umfasst einen Lautsprecher, durch den die akustischen Signale ausgegeben werden können. Entsprechende Dateien mit Toneffekten sind auf dem Speichermedium hinterlegbar.

Die elektronische Schaltung umfasst weiterhin einen Mikroprozessor und einen Zufallsgenerator. Unter einem Zufallsgenerator ist dabei jeglicher auch Hardwarebasierter Algorithmus zu verstehen, der zu einer bestimmten Ausgabe führt. Insofern ist ein Zufallsgenerator im Sinne der Erfindung auch ein solcher Algorithmus, dessen Ergebnisse in Summe keiner Idealverteilung entsprechen. Der Mikroprozessor steuert die notwendigen elektrischen und elektronischen Prozesse.

Der zumindest eine Schalter ist dafür vorgesehen, eine Entscheidungssequenz zu aktivieren. Eine Entscheidungssequenz im Sinne der Erfindung umfasst die zufallsmäßige Auswahl einer vorgesehenen Entscheidungshilfe und die Wiedergabe der ausgewählten Entscheidungshilfe in Form eines Ton- und/oder Lichteffekts. Zusätzlich können einleitende Ton- und/oder Lichteffekte - beispielsweise zur Spannungssteigerung - der ausgewählten Entscheidungshilfe im Rahmen der Entscheidungssequenz vorgeschaltet sein. Dabei ist jede Art von Kombination denkbar. Insbesondere ist es denkbar, dass die einleitenden Effekte stets gleich sind und nur die Entscheidungshilfe zufallsmäßig auswählbar ist, jedoch sind auch alternative Ausführungsformen denkbar, bei denen im Rahmen der Entscheidungssequenz sowohl die einleitenden Effekte als auch die Entscheidungshilfe per Zufall auswählbar sind.

Der zumindest eine Schalter kann prinzipiell jede Art von Schalter umfassen. Bevorzugt sind jedoch Näherungsschalter bzw. Näherungssensoren, die also eine Aktivierung der Entscheidungssequenz ohne eine Berührung der Vorrichtung ermöglichen. Insbesondere sind hierfür kapazitive Näherungsschalter geeignet, die Erfindung ist jedoch nicht auf solche Schalter beschränkt. Es sind auch Ausführungsformen denkbar, bei denen beispielsweise ein lichtsensitiver Schalter die bevorzugte Wahl sein kann.

Die Steuerung der Entscheidungssequenz ist auf verschiedene Weise denkbar. Beispielsweise kann die Entscheidungssequenz eine vorbestimmte Länge aufweisen, die durch die Aktivierung lediglich gestartet wird, dann jedoch automatisch mit festgelegter Länge abläuft. Es ist jedoch auch denkbar, dass die Entscheidungssequenz aktiviert wird und dann so lange andauert, wie der entsprechende Schalter aktiviert bleibt. Dies gibt dem Benutzer die Möglichkeit, die Länge der Entscheidungssequenz selbst zu bestimmen, um diese beispielsweise der jeweiligen Situation und geforderten Spannung anzupassen. Im Falle eines kapazitiven Näherungsschalters bedeutet dies beispielsweise, dass der Benutzer seine Hände beliebig lange um die magische Kugel kreisen lassen kann und die Ausgabe der Entscheidungshilfe erst nach Beendigung der Bewegung folgt. Dies kann bei den Betrachtern zusätzlich zu einem realistisch wirkenden Effekt führen.

Um eine ausreichende Sensibilität eines solchen kapazitiven Näherungsschalters zu gewährleisten, ist es sinnvoll, zumindest ein leitendes Element von dem Schalter bis an die Innenseite der Abdeckung oder auf die Oberseite der Abdeckung oder durch die Abdeckung bis auf die Oberfläche der Abdeckung zu führen. Sofern das leitende Element bis auf die Oberfläche geführt wird, kann dieses dort auch als Verzierung der Oberfläche dienen, was die Technizität zu verbergen helfen kann. Als leitendes Element kann auch ganz oder teilweise ein leitender Farbstoff ("conductive ink; conductive paint; conductive paste") verwendet werden. Dieser kann auf die Innen- und/oder Außenseite der Abdeckung appliziert sein

Es sind auch Ausführungsformen denkbar, bei denen die leitenden Elemente in die Abdeckung integriert sind. Welche Ausführungsform der Fachmann wählt, hängt nicht zuletzt vom gewünschten Design der Kugel und dem Wunsch, diese leitenden Elemente zu verbergen, ab.

Ein weiterer Schalter kann als typischer An-/Aus-Schalter vorgesehen sein, um die Stromversorgung beispielsweise von den Verbrauchern abzutrennen.

In einer Weiterbildung der Erfindung kann beispielsweise die Anzahl der möglichen Entscheidungen und entsprechend der möglichen Entscheidungshilfen beziehungsweise Entscheidungssequenzen durch einen vorgeschalteten Wahlvorgang, beispielsweise durch einen Wahlschalter, vorgesehen sein. Ein solcher Schalter kann als Schiebeschalter zur Auswahl vorgegebener Anzahlen ausgebildet sein. Die Auswahl der Zahl "2" entspricht einer Auswahl zwischen zwei Möglichkeiten, die Auswahl der Zahl "3" einer Auswahl zwischen drei Möglichkeiten etc.

Auch ist für die Auswahl beispielsweise ein Up-/Down-Schalter denkbar, wobei die ausgewählte Anzahl beispielsweise über einen Ton- oder Lichteffekt oder auch über ein separates Display, das vorzugsweise auf der Unterseite des Basiselements vorgesehen ist, bestätigt wird. So wäre die Vorrichtung in dieser Weiterbildung auch für Entscheidungen einsetzbar, die mehr als zwei Auswahlmöglichkeiten bieten.

Die erfindungsgemäße Vorrichtung stellt in überraschend einfacher Art und Weise eine Entscheidungshilfe bereit, die einfach zu handhaben und auch in spielerischer Weise einsetzbar ist.

Die Erfindung sowie das technische Umfeld werden nachfolgend anhand der Figuren näher erläutert. Es ist darauf hinzuweisen, dass die Figuren eine besonders bevorzugte Ausführungsvariante der Erfindung zeigen. Die Erfindung ist jedoch nicht auf die gezeigte Ausführungsvariante beschränkt. Insbesondere umfasst die Erfindung, soweit es technisch sinnvoll ist, beliebige Kombinationen der technischen Merkmale, die in den Ansprüchen aufgeführt oder in der Beschreibung als erfindungsrelevant beschrieben sind.

Es zeigen:
- Fig. 1: zeigt eine perspektivische Seitenansicht der magischen Kugel mit Basiselement und Abdeckung;
- Fig. 2: zeigt eine perspektivische Ansicht der magischen Kugel von schräg unten mit Basiselement und Abdeckung und
- Fig. 3: zeigt eine perspektivische Ansicht des Basiselements der magischen Kugel von schräg oben.

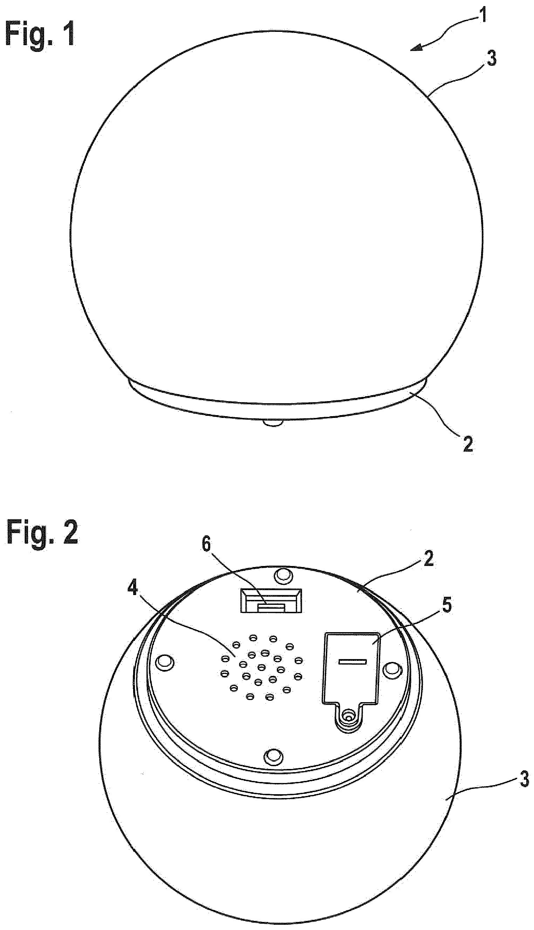

Fig. 1 zeigt eine bevorzugte Ausführungsform der erfindungsgemäßen Vorrichtung 1 mit dem Basiselement 2 und der kugelförmigen Abdeckung 3. Die Abdeckung 3 ist vorzugsweise aus einem Material gewählt, das darunter liegende Lichteffekte zumindest nicht vollständig gegenüber dem Betrachter abschirmt. Die Unterseite des Basiselements 2 ist so zu gestalten, dass diese der Vorrichtung 1 eine ausreichende Standsicherung gibt.

Fig. 2 zeigt eine perspektivische Ansicht der Vorrichtung 1 von schräg unten mit Basiselement 2 und Abdeckung 3. Vorzugsweise umfasst die Unterseite des Basiselements 2 Öffnungen 4 für den Lautsprecher, einen Zugang zu der Stromversorgung 5, beispielsweise eine Klappe zum darunterliegenden Batteriefach, und einen optionalen An-/Ausschalter 6. In einer Weiterbildung der Erfindung sind an der Unterseite des Basiselements 2 auch vorzugsweise ein Auswahlschalter zur Bestimmung der Anzahl der Entscheidungsmöglichkeiten und gegebenenfalls ein Display zur Anzeige der gewählten Entscheidungsmöglichkeiten vorgesehen (beides in Fig. 2 nicht dargestellt).

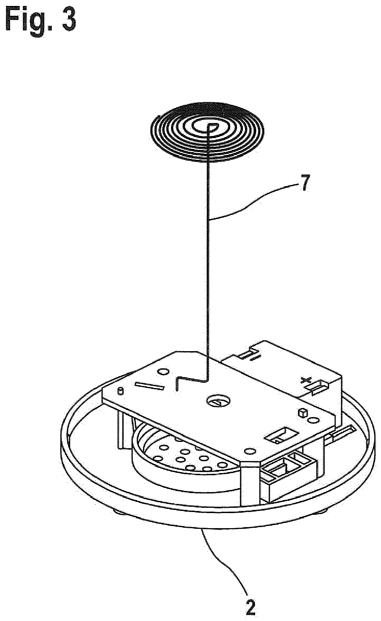

Fig. 3 zeigt eine perspektivische Ansicht des Basiselements 2 von schräg oben mit einem leitenden Element 7. Das leitende Element 7 ist mit dem kapazitiven Näherungsschalter (nicht dargestellt) verbunden und reicht in dieser Ausführungsform bis unter die Innenseite der Abdeckung (3, hier nicht dargestellt).

### Bezugszeichenliste

- 1: Vorrichtung
- 2: Basiselement
- 3: Abdeckung
- 4: Öffnungen für den Lautsprecher
- 5: Zugang zu Batteriefach
- 6: An-/Ausschalter
- 7: Leitendes Element

## Patentansprüche

1. Vorrichtung zur Ausgabe eines akustischen und/oder optischen Effekts (einer Entscheidungssequenz) mit
- einem Grundkörper umfassend ein Basiselement (2) mit einer form- und oder kraftschlüssig anbringbaren Abdeckung (3),
- mindestens einem optischen und/oder mindestens einem akustischen Reizelement,
- einer Stromversorgung,
- einem Schaltkreis mit einem Mikroprozessor, einem Zufallsgenerator und einem Speichermedium und
- zumindest einem Schalter,
**dadurch gekennzeichnet, dass** durch den zumindest einen Schalter eine Entscheidungssequenz aktivierbar ist, wobei die Entscheidungssequenz per Zufallsgenerator aus mehreren vorgesehenen Entscheidungssequenzen auswählbar ist und in Form eines optischen und/oder akustischen Reizes (Entscheidungssequenz) durch die Reizelemente ausgebbar ist.

2. Vorrichtung nach Anspruch 1, **dadurch gekennzeichnet, dass** der zumindest eine Schalter ein Näherungsschalter ist.

3. Vorrichtung nach Anspruch 1 oder 2, **dadurch gekennzeichnet, dass** der zumindest eine Schalter ein kapazitiver Näherungsschalter mit zumindest einem leitenden Element (7) ist.

4. Vorrichtung nach Anspruch 3, **dadurch gekennzeichnet, dass** zumindest ein leitendes Element (7) des kapazitiven Näherungsschalters bis an die Innenseite der Abdeckung (3) oder bis auf die Oberseite der Abdeckung (7) reicht oder in die Abdeckung (3) integriert ist.

5. Vorrichtung nach einem der vorherigen Ansprüche, **dadurch gekennzeichnet, dass** die Anzahl der möglichen Entscheidungssequenzen einstellbar ist, wobei die Einstellung der Anzahl durch einen weiteren Schalter vorgesehen ist.

6. Vorrichtung nach einem der vorherigen Ansprüche, **dadurch gekennzeichnet, dass** die Abdeckung (3) kugelförmig ausgebildet ist.

7. Vorrichtung nach einem der vorherigen Ansprüche, **dadurch gekennzeichnet, dass** ein weiterer Schalter als An-Aus-Schalter vorgesehen ist.

8. Vorrichtung nach einem der vorherigen Ansprüche, **dadurch gekennzeichnet, dass** die akustischen Reizelemente Lautsprecher sind.

9. Vorrichtung nach einem der vorherigen Ansprüche, **dadurch gekennzeichnet, dass** die optischen Reizelemente LEDs sind.

10. Vorrichtung nach einem der vorherigen Ansprüche, **dadurch gekennzeichnet, dass** die optischen und akustischen Effekte auf dem Speichermedium speicherbar sind.
